(19) Europäisches Patentamt
European Patent Office
Office européen des brevets

(11) **EP 3 660 181 A1**

(12) **EUROPÄISCHE PATENTANMELDUNG**

(43) Veröffentlichungstag:
**03.06.2020 Patentblatt 2020/23**

(51) Int Cl.:
*C23C 14/16* (2006.01)    *C23C 14/22* (2006.01)
*C23C 14/24* (2006.01)

(21) Anmeldenummer: **19209189.0**

(22) Anmeldetag: **14.11.2019**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**KH MA MD TN**

(30) Priorität: **30.11.2018 DE 102018220678**

(71) Anmelder:
• **ThyssenKrupp Steel Europe AG**
**47166 Duisburg (DE)**

• **thyssenkrupp AG**
**45143 Essen (DE)**

(72) Erfinder:
• **Schwerdt, Christian**
**47058 Duisburg (DE)**
• **Bienholz, Dr. Stefan**
**44795 Bochum (DE)**

(74) Vertreter: **ThyssenKrupp Steel Europe AG**
**Patente/Patent Department**
**Kaiser-Wilhelm-Straße 100**
**47166 Duisburg (DE)**

(54) **VERFAHREN ZUM PVD-BESCHICHTEN VON WERKSTÜCKEN**

(57) Es wird ein Verfahren zur PVD-Beschichtung eines Werkstücks (1) mit einem Beschichtungsmaterial (2) vorgeschlagen, wobei das Werkstück (1) in einer Beschichtungskammer bereitgestellt wird, wobei der Druck in der Beschichtungskammer reguliert wird, wobei das Beschichtungsmaterial (2) an einer Einströmstelle (3) in die Beschichtungskammer eingeströmt wird, wobei das Beschichtungsmaterial (2) auf eine Temperatur temperiert wird, wobei der Druck und die Temperatur des Beschichtungsmaterials (2) so eingestellt werden, dass die

Gleichung $K_n = \dfrac{k_B T}{\sqrt{2}\pi\sigma^2 p l}$ mit $K_n \leq 0,1$ erfüllt ist, wobei T die Temperatur des Beschichtungsmaterials (2) ist, $k_B$ die Boltzmann-Konstante ist, $\sigma$ der Durchmesser der Moleküle des Beschichtungsmaterials (2) ist, p der Druck ist und l die charakteristische Länge, typischerweise der Abstand von Einströmstelle (3) und Werkstück (1) ist.

Fig. 1

EP 3 660 181 A1

**Beschreibung**

**Stand der Technik**

Die vorliegende Erfindung geht aus von Verfahren zum PVD-Beschichten von Werkstücken. Verfahren zum PVD-Beschichten sind weit verbreitet. Unter PVD versteht der Fachmann physikalische Gasphasenabscheidung (englisch: physical vapour deposition). Üblicherweise wird dazu ein Beschichtungsmaterial, welches zunächst in fester oder flüssiger Form vorliegt, durch physikalische Prozesse verdampft. Dies kann beispielsweise thermisch durch direktes Aufheizen des Beschichtungsmaterials, durch Beschuss mit einem Elektronen- oder Ionenstrahl oder durch Beleuchtung mit einem Laserstrahl geschehen. Damit die Dampfteilchen des verdampften Beschichtungsmaterials das zu beschichtende Werkstück erreichen können und nicht durch Kollision mit Gasteilchen der Umgebungsatmosphäre für die Beschichtung verloren gehen, wird das Verfahren zum PVD-Beschichten in einer Beschichtungskammer unter Unterdruck durchgeführt.

Durch die Reduzierung des Druckes steigt jedoch die mittlere freie Weglänge der Dampfteilchen in der Beschichtungskammer an, so dass es immer schwieriger wird, das Beschichtungsmaterial gezielt über eine Strömung zum Werkstück zu befördern. Vielmehr bewegen sich die Dampfteilchen teils unkontrolliert in der Beschichtungskammer. Es kann dabei passieren, dass der Transport des Beschichtungsmaterials gar nicht mehr als Strömung beschrieben werden kann, sondern dass stochastische Einzelteilchenbewegungen dominant werden. Die Folge ist, dass die Dampfteilchen an allen Oberflächen der Beschichtungskammer kondensieren, deren Temperatur unterhalb der Kondensationstemperatur liegt, was zu unerwünschten Streubeschichtungen führt. Eine aus dem Stand der Technik bekannte Methode zur Verringerung von Streubeschichtungen ist das Beheizen der Oberflächen der Beschichtungskammer. Dies ist jedoch aufwendig und energieintensiv.

Der Erfindung liegt die technische Aufgabe zugrunde, ein Verfahren zum PVD-Beschichten bereitzustellen, welches die Nachteile des Standes der Technik nicht aufweist und welches es ermöglicht, das Beschichtungsmaterial durch Gasströmungen gezielt zum Werkstück zu transportieren.

Diese Aufgabe wird gelöst durch ein Verfahren zur PVD-Beschichtung eines Werkstücks mit einem Beschichtungsmaterial, wobei das Werkstück in einer Beschichtungskammer bereitgestellt wird, wobei der Druck in der Beschichtungskammer reguliert wird, wobei das Beschichtungsmaterial an einer Einströmstelle in die Beschichtungskammer eingeströmt wird, wobei das Beschichtungsmaterial auf eine Temperatur temperiert wird, wobei der Druck und die Temperatur des Beschichtungsmaterials so eingestellt werden, dass die Gleichung $K_n = \dfrac{k_B T}{\sqrt{2}\pi\sigma^2 p l}$ mit $K_n \leq 0,1$ erfüllt ist, wobei T die Temperatur des Beschichtungsmaterials ist, $k_B$ die Boltzmann-Konstante ist, $\sigma$ der Durchmesser der Moleküle des Beschichtungsmaterials ist, p der Druck ist und l die charakteristische Länge, typischerweise der Abstand von Einströmstelle und Werkstück ist.

Das erfindungsgemäße Verfahren ermöglicht das Ausbilden einer kontrollierbaren Strömung des Beschichtungsmaterials in der Beschichtungskammer. Dadurch kann das Beschichtungsmaterial gezielt auf dem Werkstück deponiert werden. Streubeschichtungen werden deutlich verringert. $K_n$ ist die sogenannte Knudsen-Zahl. Über diese dimensionslose Größe lässt sich das Strömungsverhalten einer Gasströmung abschätzen. Bei $K_n \leq 0,01$ spricht man von einer Kontinuumsströmung. Knudsen-Zahlen zwischen 0,01 und 0,1 zeigen an, dass es sich bei der betrachteten Strömung um eine Gleitströmung handelt. Liegt die Knudsen-Zahl zwischen 0,1 und 10, so liegt eine Übergangs- oder Knudsenströmung vor. Bei $K_n \geq 10$ spricht man schließlich von freier Molekularströmung. Erfindungsgemäß werden nun die Prozessparameter Druck und Temperatur so gewählt, dass eine Kontinuumsströmung oder zumindest eine Gleitströmung während des Beschichtungsprozesses vorliegt. Damit ist es möglich, das Beschichtungsmaterial gezielt zum Werkstück zu leiten. Auf dem Werkstück kondensiert das Beschichtungsmaterial und beschichtet somit das Werkstück. Die Boltzmann-Konstante beträgt circa $1,38*10^{-23}$ $J*K^{-1}$.

Ein Werkstück im Sinne der vorliegenden Erfindung kann beispielsweise auch ein Stahlband sein. Der Abstand zwischen der Einströmstelle und dem Werkstück ist dann die charakteristische Länge des Strömungskanals. Wird die charakteristische Länge mit der mittleren freien Weglänge ins Verhältnis gesetzt, so kann eine gemittelte Anzahl an Stößen der Beschichtungsatome mit anderen Gasteilchen auf dem Weg von der Einströmstelle zum Werkstück abgeschätzt werden. Nur eine ausreichende Anzahl an Stößen sorgt letztendlich für eine Kontinuums- oder Gleitströmung. Typischerweise liegt der Abstand zwischen der Einströmstelle und dem Werkstück im Zentimeterbereich.

Vorteilhafte Ausgestaltungen und Weiterbildungen der Erfindung sind den Unteransprüchen, sowie der Beschreibung unter Bezugnahme auf die Zeichnungen entnehmbar.

Gemäß einer bevorzugten Ausführungsform der vorliegenden Erfindung ist vorgesehen, dass $K_n \leq 0,05$ ist, wobei vorzugsweise $K_n \leq 0,01$ ist. Kontinuumsströmungen lassen sich leichter kontrollieren als Gleitströmungen, womit es zu geringeren Streubeschichtungen kommt.

Gemäß einer weiteren bevorzugten Ausführungsform der vorliegenden Erfindung ist vorgesehen, dass Druck und Temperatur so eingestellt werden, dass die Temperatur oberhalb des Taupunktes des Beschichtungsmaterials liegt. Bei einer Temperatur oberhalb des Taupunktes des Beschichtungsmaterials liegt das Beschichtungsmaterial in seiner gasförmigen Phase vor. Wird der Druck angepasst, beispielsweise erhöht, so verschiebt sich der Taupunkt, im Beispiel hin zu höheren Temperaturen. Eine entsprechende Nachregulierung der Temperatur sorgt dafür, dass das Beschichtungsmaterial gasförmig vorliegt.

Gemäß einer weiteren bevorzugten Ausführungsform der vorliegenden Erfindung ist vorgesehen, dass der Druck auf zwischen 1 mbar und 100 mbar, vorzugsweise auf zwischen 10 mbar und 100 mbar, eingestellt wird. Dies sorgt dafür, dass wenig Beschichtungsmaterial durch Streuung an Teilchen in der Beschichtungskammer für die Beschichtung verloren geht. Gleichzeitig liegt der Druck in einem Bereich, der bei der gewerblichen Anwendung in industriellen Anlagen, beispielsweise bei der Beschichtung von Stahlbändern, realisierbar ist.

Gemäß einer weiteren bevorzugten Ausführungsform der vorliegenden Erfindung ist vorgesehen, dass der Abstand von Einströmstelle und Werkstück zwischen 0,5 cm und 50 cm, vorzugsweise zwischen 1 cm und 25 cm und besonders bevorzugt zwischen 1 cm und 15 cm beträgt. Mit den genannten Abständen lassen sich Beschichtungskammern konstruieren, welche im Gebrauch leicht zu handhaben sind. Weiterhin ist es aber auch noch möglich, bei den genannten Abständen kontrollierbare Gasströmungen zu erzeugen.

Gemäß einer weiteren bevorzugten Ausführungsform der vorliegenden Erfindung ist vorgesehen, dass zusätzlich zum Beschichtungsmaterial ein Inertgas an einer weiteren Einströmstelle in die Beschichtungskammer eingeströmt wird und als Druck der Gesamtdruck bestehend aus dem Partialdruck des Beschichtungsmaterials und dem Partialdruck des Inertgases gewählt wird, wobei zum Einstellen des Druckes der Partialdruck des Beschichtungsmaterials und der Partialdruck des Inertgases eingestellt werden. Reicht der Partialdruck des Beschichtungsmaterials nicht für eine Gleit- oder Kontinuumsströmung aus, so kann durch das Inertgas der Gesamtdruck soweit erhöht werden, dass eine Gleit- oder Kontinuumsströmung vorliegt. Denkbar ist, dass die weitere Einströmstelle von der Einströmstelle entfernt angeordnet ist. Denkbar ist aber auch, dass das Beschichtungsmaterial mit dem Inertgas gemischt in die Beschichtungskammer eingeströmt wird.

Vorzugsweise ist vorgesehen, dass als Beschichtungsmaterial Zink oder Zinklegierungen verwendet werden.

Mit der folgenden Tabelle sollen einige Beispiele für Kombinationen aus Druck, Temperatur und Abstand von Einströmstelle und Werkstück gezeigt werden. In der Tabelle ist der errechnete Taupunkt für Zink als Beschichtungsmaterial und die errechnete Knudsen-Zahl für Zink bei einer dem Taupunkt entsprechenden Temperatur gezeigt. Die mit * bezeichnete Spalte gibt an, ob es sich in der entsprechenden Zeile um einen Druck, Temperatur und Abstand gemäß einer bevorzugten Ausführungsform der vorliegenden Erfindung handelt.

| Druck [mbar] | Taupunkt [K] | Abstand [m] | Knudsen-Zahl | * |
|---|---|---|---|---|
| 100 | 985 | 0,01 | 0,002 | Ja |
| 10 | 851 | 0,02 | 0,007 | Ja |
| 1 | 750 | 0,02 | 0,06 | Ja |
| 1 | 750 | 0,15 | 0,009 | Ja |
| 0,25 | 700 | 0,02 | 0,24 | Nein |

Gemäß einer weiteren bevorzugten Ausführungsform der vorliegenden Erfindung ist vorgesehen, dass als Inertgas Stickstoff und/oder Argon verwendet wird. Stickstoff und Argon eignen sich hervorragend als Inertgas. Beide Gase beeinflussen die PVD-Beschichtung nicht negativ und sind ferner geeignet, die Beschichtungskammer zu spülen.

Gemäß einer weiteren bevorzugten Ausführungsform der vorliegenden Erfindung ist vorgesehen, dass das Inertgas, insbesondere vor der Einströmstelle vorgewärmt wird, um ein Abkühlen des Beschichtungsmaterials zu verhindern.

Gemäß einer weiteren bevorzugten Ausführungsform der vorliegenden Erfindung ist vorgesehen, dass als weitere Einströmstelle die Einströmstelle des Beschichtungsmaterials verwendet wird. Dies ermöglicht ein Einströmen des Beschichtungsmaterials und des Inertgases als Gemisch in die Beschichtungskammer aus einer Einströmstelle.

Gemäß einer weiteren bevorzugten Ausführungsform der vorliegenden Erfindung ist vorgesehen, dass die Beschichtungskammer zumindest teilweise geheizt wird. Dies bewirkt eine weitere Verringerung der Streubeschichtung in der Beschichtungskammer.

Gemäß einer weiteren bevorzugten Ausführungsform der vorliegenden Erfindung ist vorgesehen, dass als Einströmstelle eine Düse verwendet wird. Damit ist es vorteilhaft möglich, die Richtung des einströmenden Beschichtungsmaterials zu steuern. Denkbar ist auch, dass als weitere Einströmstelle eine weitere Düse verwendet wird. Gemäß einer weiteren bevorzugten Ausführungsform der vorliegenden Erfindung ist vorgesehen, dass das Beschichtungsmaterial unter einem Winkel zur zu einer zu beschichtenden Oberfläche des Werkstücks eingeströmt wird, wobei der Winkel größer als 0° und kleiner als 90° ist, wobei der Winkel bevorzugt zwischen 10° und 80°, besonders bevorzugt zwischen 30° und 70° und insbesondere etwa 45° ist. Dies ermöglicht auf vorteilhafte Weise, das Beschichtungsmaterial entlang der Oberfläche des zu beschichtenden Werkstücks strömen zu lassen. Die Folge ist eine gleichmäßige Beschichtung der Oberfläche des Werkstücks mit dem Beschichtungsmaterial.

Gemäß einer weiteren bevorzugten Ausführungsform der vorliegenden Erfindung ist vorgesehen, dass das Werkstück durch die Beschichtungskammer bewegt wird, während das Beschichtungsmaterial eingeströmt wird. Dies ermöglicht auf vorteilhafte Weise das gleichmäßige Beschichten von großen Werkstücken. Denkbar ist, dass das Werkstück an der Einströmstelle und/oder der weiteren Einströmstelle vorbeibewegt wird. Vorzugsweise wird das Werkstück dabei gleichmäßig bewegt. Denkbar ist ferner, dass das Werkstück bandförmig ist und kontinuierlich an der Einströmstelle vorbeibewegt wird.

Gemäß einer weiteren bevorzugten Ausführungsform der vorliegenden Erfindung ist vorgesehen, dass Gas aus der Beschichtungskammer abgesaugt wird. Damit ist eine weitere Möglichkeit der Beeinflussung der Strömungsrichtung des Beschichtungsmaterials und des Inertgases in der Beschichtungskammer möglich. Weiterhin ist denkbar, dass Beschichtungsmaterial in gasförmiger Form, in flüssiger Form oder in fester Form vor der Kondensation an Kammerwänden oder Einbauten der Beschichtungskammer durch das Absaugen entsorgt wird.

Weitere Einzelheiten, Merkmale und Vorteile der Erfindung ergeben sich aus den Zeichnungen, sowie aus der nachfolgenden Beschreibung von bevorzugten Ausführungsformen anhand der Zeichnungen. Die Zeichnungen illustrieren dabei lediglich beispielhafte Ausführungsformen der Erfindung, welche den wesentlichen Erfindungsgedanken nicht einschränken.

**Kurze Beschreibung der Zeichnungen**

Figur 1    zeigt schematisch das Verfahren gemäß einer beispielhaften Ausführungsform der vorliegenden Erfindung.

Figur 2    zeigt schematische Verfahren gemäß einer beispielhaften Ausführungsform der vorliegenden Erfindung.

**Ausführungsformen der Erfindung**

In den verschiedenen Figuren sind gleiche Teile stets mit den gleichen Bezugszeichen versehen und werden daher in der Regel auch jeweils nur einmal benannt bzw. erwähnt.

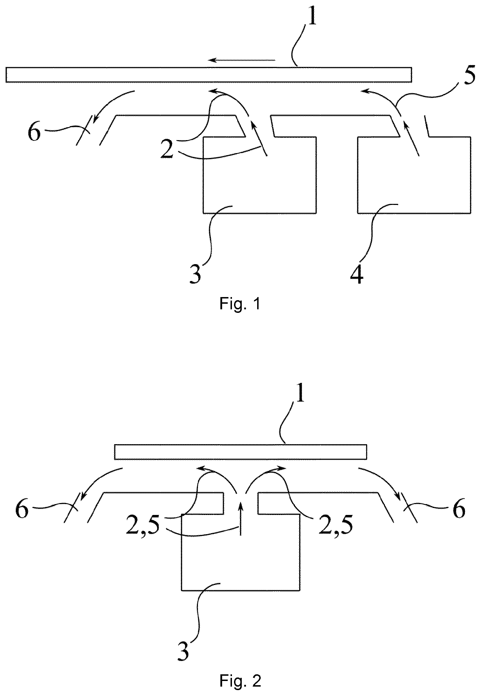

In **Figur 1** ist das Verfahren gemäß einer beispielhaften Ausführungsform der vorliegenden Erfindung schematisch dargestellt. Das Werkstück 1 ist in der Beschichtungskammer bereitgestellt. An der Einströmstelle 3 wird das Beschichtungsmaterial 2, hier zum Beispiel Nickel, mit einem Elektronenstrahl beschossen und verdampft. Das als Dampf in die Beschichtungskammer in Richtung des Werkstücks 1 strömende Beschichtungsmaterial 2 hat die Temperatur T und den Partialdruck $p_B$. Der Partialdruck $p_B$ des Beschichtungsmaterials 2 und die Temperatur T werden so eingestellt, dass das Beschichtungsmaterial 2 nach Verlassen der Einströmstelle 3 gasförmig ist. An der weiteren Einströmstelle 4 wird das Inertgas 5, hier zum Beispiel Stickstoff und Argon eingeströmt. Das Inertgas 5 hat den Partialdruck $p_I$ des Inertgases. Die Partialdrücke $p_B$ und $p_I$ ergeben den Druck p. Druck und Temperatur werden nun so eingestellt, dass sie zusammen mit dem maximalen Abstand l zwischen der Einströmstelle 3 und dem Werkstück 1 der Gleichung

$$0{,}01 \geq \frac{k_B T}{\sqrt{2}\pi\sigma^2 p l}$$ genügt. Hierbei ist $k_B$ die Boltzmann-Konstante und $\sigma$ ist der Durchmesser der Moleküle des Beschichtungsmaterials 2. Die Einströmstelle 3 und die weitere Einströmstelle 4 sind jeweils als Düse ausgeführt. Durch die Einstellung der Düse der Einströmstelle 3 wird das Beschichtungsmaterial 2 gezielt in der gewünschten Richtung in die Beschichtungskammer auf das Werkstück 1 eingeströmt.

Das Beschichtungsmaterial 2 kondensiert an der Oberfläche des Werkstücks 1 und beschichtet dieses. Überflüssiges Beschichtungsmaterial 2 und das Inertgas 5 werden an der Absaugung 6 aus der Beschichtungskammer abgesaugt. Zur gleichmäßigen Beschichtung wird das Werkstück 1, hier zum Beispiel ein Stahlband, an der Einströmstelle 3 vorbei bewegt.

In **Figur 2** ist das Verfahren gemäß einer beispielhaften Ausführungsform der vorliegenden Erfindung schematisch dargestellt. Das Werkstück 1 ist ortsfest in der Beschichtungskammer bereitgestellt. An der Einströmstelle 3 wird das Beschichtungsmaterial 2, hier zum Beispiel Nickel, thermisch erwärmt und verdampft. Dem verdampften Beschichtungsmaterial 2 wird in der Einströmstelle 3 das Inertgas 5 beigemischt. Zusammen mit dem Inertgas 5 strömt das Beschichtungsmaterial 2 entlang der Oberfläche des Werkstücks 1, wobei das Beschichtungsmaterial 2 die Temperatur T und den Partialdruck p_B hat. Der Partialdruck p_B des Beschichtungsmaterials 2 und die Temperatur T werden so eingestellt, dass das Beschichtungsmaterial 2 nach Verlassen der Einströmstelle 3 gasförmig ist. Das Inertgas 5 hat den Partialdruck p_I des Inertgases. Die Partialdrücke p_B und p_I ergeben den Druck p. Druck und Temperatur werden nun so eingestellt, dass sie zusammen mit dem maximalen Abstand l zwischen der Einströmstelle 3 und dem Werkstück 1 der Gleichung $0{,}01 \geq \dfrac{k_B T}{\sqrt{2}\pi\sigma^2 p l}$ genügt. Hierbei ist $k_B$ die Boltzmann-Konstante und $\sigma$ ist der Durchmesser der Moleküle des Beschichtungsmaterials 2. Die Einströmstelle 3 ist als Düse ausgeführt. Durch die Einstellung der Düse der Einströmstelle 3 werden das Beschichtungsmaterial 2 und das Inertgas 5 gezielt in der gewünschten Richtung in die Beschichtungskammer auf das Werkstück 1 eingeströmt.

Das Beschichtungsmaterial 2 kondensiert an der Oberfläche des Werkstücks 1 und beschichtet dieses. Überflüssiges Beschichtungsmaterial 2 und das Inertgas 5 werden an den Absaugungen 6 aus der Beschichtungskammer abgesaugt.

**Bezugszeichenliste**

1 Werkstück
2 Beschichtungsmaterial
3 Einströmstelle
4 weitere Einströmstelle
5 Inertgas
6 Absaugung

**Patentansprüche**

1. Verfahren zur PVD-Beschichtung eines Werkstücks (1) mit einem Beschichtungsmaterial (2), wobei das Werkstück (1) in einer Beschichtungskammer bereitgestellt wird, wobei der Druck in der Beschichtungskammer reguliert wird, wobei das Beschichtungsmaterial (2) an einer Einströmstelle (3) in die Beschichtungskammer eingeströmt wird, wobei das Beschichtungsmaterial (2) auf eine Temperatur temperiert wird, wobei der Druck und die Temperatur des Beschichtungsmaterials (2) so eingestellt werden, dass die Gleichung $K_n = \dfrac{k_B T}{\sqrt{2}\pi\sigma^2 p l}$ mit $K_n \leq 0{,}1$ erfüllt ist, wobei T die Temperatur des Beschichtungsmaterials (2) ist, $k_B$ die Boltzmann-Konstante ist, $\sigma$ der Durchmesser der Moleküle des Beschichtungsmaterials (2) ist, p der Druck ist und l die charakteristische Länge, insbesondere der Abstand von Einströmstelle (3) und Werkstück (1) ist.

2. Verfahren nach Anspruch 1, wobei $K_n \leq 0{,}05$ ist, wobei vorzugsweise $K_n \leq 0{,}01$ ist.

3. Verfahren nach einem der vorstehenden Ansprüche, wobei Druck und Temperatur so eingestellt werden, dass die Temperatur oberhalb des Taupunktes des Beschichtungsmaterials (2) liegt.

4. Verfahren nach einem der vorhergehenden Ansprüche, wobei der Druck auf zwischen 1 mbar und 100 mbar, vorzugsweise auf zwischen 10 mbar und 100 mbar, eingestellt wird.

5. Verfahren nach einem der vorhergehenden Ansprüche, wobei der Abstand von Einströmstelle (3) und Werkstück (1) zwischen 0,5 cm und 50 cm, vorzugsweise zwischen 1 cm und 25 cm und besonders bevorzugt zwischen 1 cm und 15 cm beträgt.

6. Verfahren nach einem der vorhergehenden Ansprüche, wobei zusätzlich zum Beschichtungsmaterial (2) ein Inertgas (5) an einer weiteren Einströmstelle (4) in die Beschichtungskammer eingeströmt wird und als Druck der Gesamtdruck bestehend aus dem Partialdruck des Beschichtungsmaterials (2) und dem Partialdruck des Inertgases (5) gewählt wird, wobei zum Einstellen des Druckes der Partialdruck des Beschichtungsmaterials (2) und der Partialdruck des Inertgases (5) eingestellt werden.

7. Verfahren nach einem der vorhergehenden Ansprüche, wobei als Beschichtungsmaterial (2) Zink oder Zinklegierung verwendet wird.

8. Verfahren nach einem der Ansprüche 6 bis 7, wobei als Inertgas (5) Stickstoff und/oder Argon verwendet wird.

9. Verfahren nach einem der Ansprüche 6 bis 8, wobei das Inertgas (5), insbesondere vor der Einströmstelle (4) vorgewärmt wird.

10. Verfahren nach einem der Ansprüche 6 bis 9, wobei als weitere Einströmstelle (4) die Einströmstelle (3) des Beschichtungsmaterials (2) verwendet wird.

11. Verfahren nach einem der vorhergehenden Ansprüche, wobei die Beschichtungskammer zumindest teilweise geheizt wird.

12. Verfahren nach einem der vorhergehenden Ansprüche, wobei als Einströmstelle (3) eine Düse verwendet wird.

13. Verfahren nach einem der vorhergehenden Ansprüche, wobei das Beschichtungsmaterial (2) unter einem Winkel zur zu einer zu beschichtenden Oberfläche des Werkstücks (1) eingeströmt wird, wobei der Winkel größer als 0° und kleiner als 90° ist, wobei der Winkel bevorzugt zwischen 10° und 80°, besonders bevorzugt zwischen 30° und 70° und insbesondere etwa 45° ist.

14. Verfahren nach einem der vorhergehenden Ansprüche, wobei das Werkstück (1) durch die Beschichtungskammer bewegt wird während das Beschichtungsmaterial (2) eingeströmt wird.

15. Verfahren nach einem der vorhergehenden Ansprüche, wobei Gas aus der Beschichtungskammer abgesaugt wird.

Fig. 1

Fig. 2

Europäisches
Patentamt

European
Patent Office

Office européen
des brevets

# EUROPÄISCHER RECHERCHENBERICHT

Nummer der Anmeldung

EP 19 20 9189

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | EP 2 036 996 A1 (SULZER METCO AG [CH]) 18. März 2009 (2009-03-18) * Absätze [0037] - [0038], [0050], [0056] * | 1-15 | INV. C23C14/16 C23C14/22 C23C14/24 |
| | ----- | | |
| A | JP 2018 127662 A (CANON KK) 16. August 2018 (2018-08-16) * Absatz [0030] * | 1-15 | |
| | ----- | | |
| A | US 2013/260537 A1 (VON KAENEL HANS [CH]) 3. Oktober 2013 (2013-10-03) * Absätze [0029], [0036], [0050] * | 1-15 | |
| | ----- | | |

RECHERCHIERTE SACHGEBIETE (IPC)

C23C

Der vorliegende Recherchenbericht wurde für alle Patentansprüche erstellt

| Recherchenort | Abschlußdatum der Recherche | Prüfer |
|---|---|---|
| Den Haag | 20. April 2020 | Peijzel, Paul |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus anderen Gründen angeführtes Dokument
    ......................................................................................
& : Mitglied der gleichen Patentfamilie, übereinstimmendes
    Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 19 20 9189

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

20-04-2020

| Im Recherchenbericht angeführtes Patentdokument | | Datum der Veröffentlichung | Mitglied(er) der Patentfamilie | | Datum der Veröffentlichung |
|---|---|---|---|---|---|
| EP 2036996 | A1 | 18-03-2009 | KEINE | | |
| JP 2018127662 | A | 16-08-2018 | JP | 6570561 B2 | 04-09-2019 |
| | | | JP | 2018127662 A | 16-08-2018 |
| US 2013260537 | A1 | 03-10-2013 | AU | 2006224282 A1 | 21-09-2006 |
| | | | CA | 2597623 A1 | 21-09-2006 |
| | | | CN | 101128911 A | 20-02-2008 |
| | | | EP | 1872383 A2 | 02-01-2008 |
| | | | JP | 5214251 B2 | 19-06-2013 |
| | | | JP | 2008532306 A | 14-08-2008 |
| | | | KR | 20070114361 A | 03-12-2007 |
| | | | KR | 20120054093 A | 29-05-2012 |
| | | | SG | 160345 A1 | 29-04-2010 |
| | | | US | 2008152903 A1 | 26-06-2008 |
| | | | US | 2013260537 A1 | 03-10-2013 |
| | | | WO | 2006097804 A2 | 21-09-2006 |

EPO FORM P0461

Für nähere Einzelheiten zu diesem Anhang : siehe Amtsblatt des Europäischen Patentamts, Nr.12/82